# FASCICULE DE BREVET EUROPEEN

(11) **EP 1 825 018 B1**
(45) Date de publication et mention de la délivrance du brevet: **10.07.2013**
(21) Numéro de dépôt: 05824491.4
(22) Date de dépôt: 07.12.2005
(51) Int. Cl.: C30B 23/06, C30B 29/54, C23C 14/26, C23C 14/24

(54) **DISPOSITIF DE DÉPÔT SOUS VIDE A RESERVOIR DE RECHARGE ET PROCÉDÉ DE DÉPÔT SOUS VIDE CORRESPONDANT**
VORRICHTUNG ZUR VAKUUMABSCHEIDUNG MIT WIEDERBEFÜLLUNGSBEHÄLTER UND ENTSPRECHENDES VAKUUMABSCHEIDUNGSVERFAHREN
DEVICE FOR VACUUM DEPOSITION WITH RECHARGING RESERVOIR AND CORRESPONDING VACUUM DEPOSITION METHOD

(30) Priorité: 07.12.2004 FR 0413025
(43) Date de publication de la demande: 29.08.2007
(73) Titulaire: Riber S.A., 95873 Bezons Cedex (FR)
(72) Inventeur: GUYAUX, Jean-Louis, F-91380 Chilly Mazarin (FR); STEMMELEN, Franck, F-95280 Jouy-le-Moutier (FR); BOUCHAIB, Pierre, F-78711 Mantes La Ville (FR)
(74) Mandataire: Michelet, Alain
(86) Numéro de dépôt international: PCT/FR2005/003072
(87) Numéro de publication internationale: WO 2006/061517

(56) Documents cités:
- EP-A- 0 581 496
- EP-A- 1 357 200
- WO-A-00/46418
- WO-A-92/03588
- US-A- 6 101 816
- PATENT ABSTRACTS OF JAPAN vol. 2003, no. 06, 3 juin 2003 (2003-06-03) & JP 2003 034591 A (NIPPON BIITEC:KK), 7 février 2003 (2003-02-07)
- DATABASE WPI Section Ch, Week 200401 Derwent Publications Ltd., London, GB; Class M13, AN 2004-007067 XP002331388 & KR 2003 067 146 A (SAMSUNG NEC MOBILE DISPLAY) 14 août 2003 (2003-08-14)

## Description

La présente invention se rapporte au domaine du dépôt sous vide. Elle concerne plus particulièrement le dépôt sous vide de films minces de matériau organique, par exemple pour la fabrication de diodes électroluminescentes à base de matériaux organiques (OLED).

La structure d'une cellule élémentaire d'un dispositif OLED est constituée d'un empilement de couches organiques très fines en sandwich entre une anode transparente et une cathode métallique. La fabrication de ces couches organiques se fait par évaporation du ou des matériaux constituant les couches et dépôt sous vide.

Un des problèmes que pose ce procédé de fabrication est celui de l'introduction dans une enceinte sous vide contenant le substrat à traiter du matériau organique évaporé.

Un appareil connu utilisé pour mettre en oeuvre ce procédé, décrit par exemple dans le brevet US4553022, comprend une cellule d'effusion thermique constituée d'un creuset qui contient le matériau organique à évaporer et un four permettant le chauffage du creuset. Cette cellule d'effusion thermique peut être introduite dans l'enceinte. Le matériau contenu dans le creuset est alors chauffé à une température donnée à laquelle le matériau évaporé s'échappe par l'orifice du creuset vers la surface du substrat où il se dépose pour former un film mince. Pour interrompre l'opération de dépôt du film mince, on interpose entre le creuset et le substrat un cache qui fait obstacle au flux de vapeur. Le matériau va alors se déposer sur la surface du cache ou sur les parois intérieures de l'enceinte et n'est par conséquent plus utilisable.

Par ailleurs, le four de chauffage du creuset se trouve en regard du substrat dans l'enceinte à vide et la chaleur qu'il émet risque d'endommager le film mince déposé.

Finalement, il faut ouvrir l'enceinte pour recharger le creuset et par conséquent remettre cette enceinte à l'air. Il faut faire de même pour intervenir sur le four qui se trouve dans l'enceinte.

Il existe dans le domaine technique de l'épitaxie par jet moléculaire (MBE) des brevets, tels US5080870 ou US5156815, qui décrivent un appareil dans lequel l'enceinte principale contenant le substrat communique avec une enceinte secondaire adaptée à recevoir un réservoir contenant le matériau à évaporer. Un tube d'injection peut être ouvert ou fermé par une vanne. L'enceinte secondaire et le réservoir sont chacun pourvus de couvercles étanches respectifs permettant une fermeture hermétique. L'enceinte secondaire et l'enceinte principale sont raccordées par une bride étanche. Un dispositif de chauffage entoure le réservoir mais également le tube d'injection.

Un tel appareil permet de contrôler le flux de vapeur au moyen de la vanne disposée entre le réservoir et l'enceinte principale.

Toutefois, là encore, le réservoir ne peut être rechargé qu'après ouverture du couvercle étanche de l'enceinte secondaire, ce qui fait que l'ensemble enceinte secondaire/enceinte principale se trouve mis à l'air.

Le document EP1357200 décrit aussi un système de dépôt sous vide comprenant une e ceinte adaptée à recevoir un substrat à traiter et à être mise sous vide et au moins un injecteur pour générer un jet moléculaire de vapeur d'un matériau organique, ledit injecteur comprenant un conduit se trouvant a l'intérieur de ladite enceinte et traversant une paroi d'injection de ladite enceinte pour former un embout extérieur adapté a être raccordé hermétiquement, de manière détachable, à un moyen d'alimentation en matériau organique, caractérisé en ce que ledit moyen d'alimentation est une bouteille et en ce que ledit dispositif de dépôt comprend, de part et d'autre de ladite paroi d'injection, un dispositif extérieur de chauffage entourant ladite bouteille et un dispositif intérieur de chauffage, une vanne réglable permettant de régler la conductance de l'injecteur intervenant a l'intérieur de l'enceinte. Toutefois le goulot n'est pas adapté a être introduit dans ledit embout et le dispositif intérieur de chauffage n'entoure pas ledit conduit.

La présente invention entend remédier aux inconvénients de l'art antérieur en proposant un dispositif et un procédé permettant de produire des vapeurs sous vide de matériaux organiques dans lequel un réservoir de produit peut être facilement rechargé.

A cet effet elle propose un dispositif de dépôt sous vide comprenant une enceinte adaptée à recevoir un substrat à traiter et à être mise sous vide et au moins un injecteur pour générer un jet moléculaire de vapeur d'un matériau organique, ledit injecteur comprenant un conduit se trouvant à l'intérieur de ladite enceinte et traversant une paroi d'injection de ladite enceinte pour former un embout extérieur adapté à être raccordé hermétiquement, de manière détachable, à un moyen d'alimentation en matériau organique, caractérisé en ce que ledit moyen d'alimentation est une bouteille dont le goulot est adapté à être introduit dans ledit embout et en ce que ledit dispositif de dépôt comprend, de part et d'autre de ladite paroi d'injection, un dispositif extérieur de chauffage entourant ladite bouteille et un dispositif intérieur de chauffage entourant ledit conduit, une vanne réglable permettant de régler la conductance de l'injecteur intervenant à l'intérieur de l'enceinte.

Ce dispositif permet une recharge en matériaux organiques s'effectuant depuis l'extérieur de l'enceinte à vide, l'opération de recharge n'obligeant pas à mettre l'enceinte à vide à l'air. La capacité en matériaux organiques peut être ajustée quelle que soit la taille de la chambre.

Selon un autre aspect de la présente invention, ledit conduit dudit injecteur est pourvu d'un dispositif de chauffage adapté à empêcher le dépôt du matériau organique sur ledit conduit.

Selon un autre aspect de la présente invention, ladite vanne est pourvue d'un dispositif de chauffage adapté à empêcher le dépôt du matériau organique sur ladite vanne.

Avantageusement, ledit réservoir amovible a une forme de bouteille avec un corps cylindrique et un goulot dont l'extrémité est adaptée à être introduite dans l'extrémité extérieure dudit conduit dudit injecteur.

Avantageusement, ledit réservoir amovible comprend, à l'intérieur de son corps cylindrique, une pluralité d'ailettes métalliques s'étendant radialement entre la paroi dudit réservoir et un tube central s'étendant sur toute la hauteur dudit corps cylindrique.

Un tel dispositif permet d'améliorer la transmission de la chaleur vers l'intérieur du réservoir, de manière à éviter l'accumulation du produit dans la zone centrale du réservoir.

Selon un autre mode de réalisation de la présente invention, ledit réservoir amovible a un corps cylindrique de section annulaire.

De la sorte, un dispositif de chauffage peut être introduit axialement par le fond dudit réservoir. C'est une autre manière d'éviter l'accumulation du produit dans la zone centrale du réservoir.

Avantageusement, ledit réservoir amovible est pourvu d'une vanne au niveau de son goulot.

Selon un autre aspect de la présente invention, ledit conduit dudit injecteur est vertical et il traverse le fond de ladite enceinte à vide, ledit substrat s'étendant horizontalement dans une partie supérieure de ladite enceinte.

Avantageusement, ledit four de chauffage chauffe ledit réservoir avec un gradient de température entre la base et le goulot de ce réservoir, entre le goulot et la vanne et entre la vanne et l'embouchure intérieure du conduit.

La présente invention concerne également un procédé de dépôt sous vide utilisant un dispositif tel que défini ci-dessus, caractérisé en ce qu'il comprend les étapes de recharge consistant à :
fermer ladite vanne ;
détacher ledit réservoir dudit injecteur ;
recharger ledit réservoir ;
raccorder ledit réservoir audit injecteur ;
ouvrir progressivement la vanne ;
chauffer ledit conduit ;
chauffer ladite vanne ; et
chauffer ledit réservoir.

On comprendra mieux l'invention à l'aide de la description, faite ci-après à titre purement explicatif, d'un mode de réalisation de l'invention, en référence aux figures annexées, où :
la figure 1 est une vue schématique d'un dispositif de dépôt sous vide à réservoir de recharge selon l'invention ;

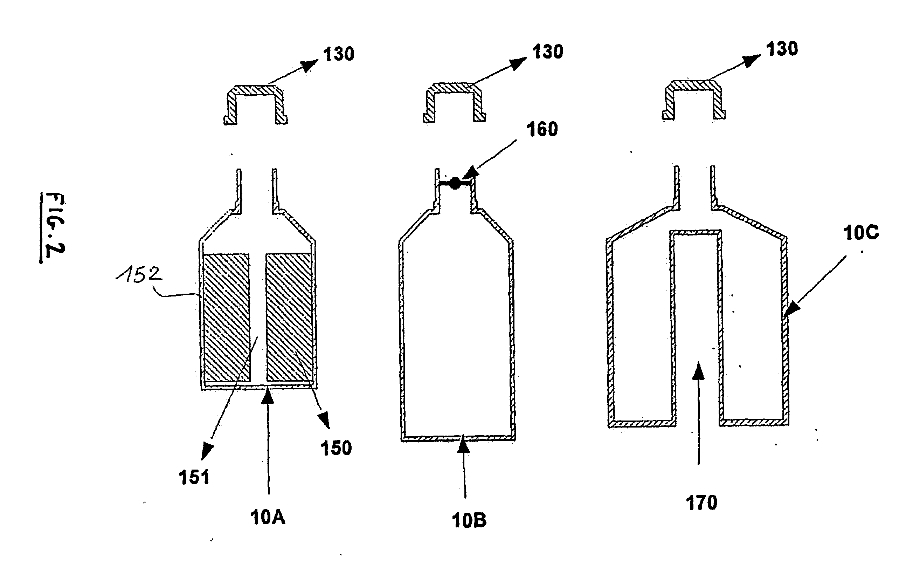

la figure 2 est une vue schématique de modes alternatifs de réalisation de réservoirs de recharge pour le dispositif de la figure 1 ; et
la figure 3 est une vue schématique illustrant les différentes étapes de recharge d'un procédé de dépôt sous vide selon la présente invention.

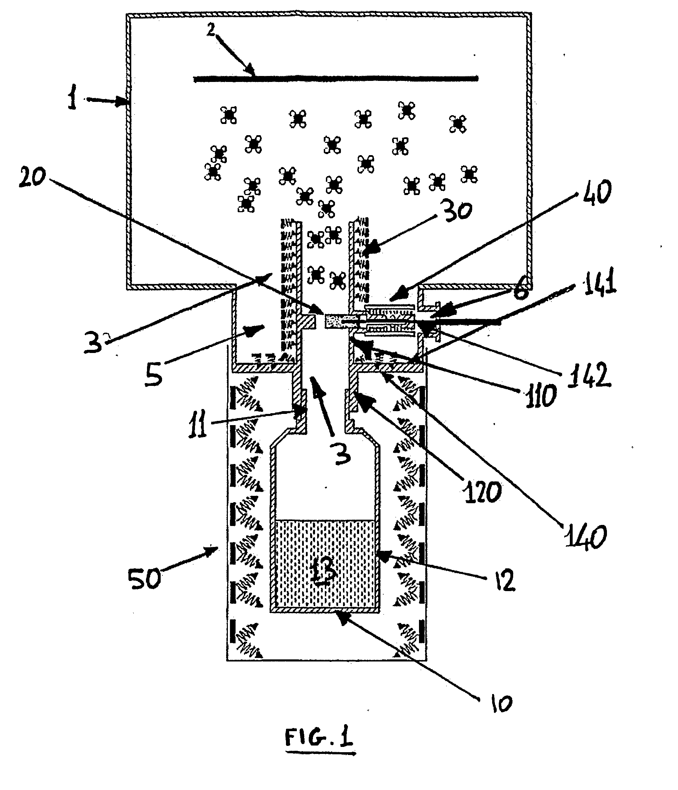

La figure 1 représente schématiquement un dispositif pour le dépôt sous vide de films minces. Il peut s'agir de dépôt de matériaux organiques ou de matériaux à forte tension de vapeur que l'on désignera par la suite par le terme de charge. Un tel dispositif servira par exemple pour la fabrication de diodes électroluminescentes à base de matériaux organiques (OLED). La charge est solide dans des conditions normales de température et de pression.

Ce dispositif comporte une enceinte 1 adaptée à recevoir un substrat 2 s'étendant horizontalement dans une partie supérieure de l'enceinte 1. Le fond de l'enceinte comporte un compartiment d'injection 5 de forme cylindrique ouvert en haut sur l'enceinte et fermé en bas par une paroi 141.

Une cellule d'injection 3 est adaptée à injecter dans l'enceinte 1 une charge sous forme d'un jet de vapeur s'étendant sensiblement sous forme d'un cône dont les dimensions sont telles que le substrat 2 forme sensiblement la base de ce cône.

La cellule d'injection 3 comprend un injecteur cylindrique vertical traversant la paroi 141 du compartiment d'injection 5. L'injecteur peut être monté de manière permanente sur l'enceinte ou de manière amovible, afin notamment de permettre son remplacement par un autre injecteur, par exemple pour modifier les caractéristiques d'injection. Le conduit de l'injecteur comprend une partie principale 110 qui s'étend à l'intérieur de ladite enceinte et un embout 120 qui s'étend à l'extérieur de ladite enceinte.

Le conduit d'injecteur 110 a une forme adaptée à la génération d'un jet moléculaire ayant la forme souhaitée. Ce conduit peut se terminer par une embouchure en forme de tronc de cône, de diffuseur étendu de type pommeau ou de bec de gaz ou tout type de diffuseur connu.

L'embout extérieur 120 est adapté à recevoir le goulot 11 d'un réservoir amovible 10 de charge. La partie extérieure 120 du conduit formant embout est conçue pour être la plus courte possible en fonction des contraintes d'accrochage du réservoir 10.

Une vanne 20 est ménagée sur la partie intérieure 110 de l'injecteur. Cette vanne est adaptée, en position fermée, à fermer hermétiquement le conduit.

La vanne 20 est montée coulissante dans un logement transversal de manière à pouvoir se déplacer perpendiculairement à l'axe de l'injecteur entre une position de fermeture où elle bouche totalement le conduit de cet injecteur et une position d'ouverture. Cette vanne est commandée par une tige 142 s'étendant transversalement dans le compartiment d'injection 5 et commandable par un manche se trouvant à l'extérieur de l'enceinte 1, la traversée de l'enceinte étant assurée à travers un dispositif étanche 6.

La vanne 20 permet de régler la conductance de l'injecteur, c'est-à-dire de faire varier de manière continue le débit de molécules. Avantageusement, la vanne est pilotée par un moteur agissant sur la tige 142. Ce moteur peut être asservi à un contrôleur qui, en utilisant un signal provenant d'un dispositif de mesure sensible au flux de molécules (balance à quartz), ajuste la position de la vanne afin de maintenir le flux de molécules à une valeur prédéterminée par l'opérateur. Le pilotage du moteur de la vanne permet à un utilisateur d'obtenir des profils de flux de molécules en fonction du temps prédéfinis en programmant les positions successives de la vanne.

Le réservoir amovible 10 de charge a globalement la forme d'une bouteille avec un corps cylindrique 12 et un goulot 11 dont l'extrémité est adaptée à être introduite dans l'embout 120 de l'injecteur. Le goulot est connecté de manière étanche à l'embout de l'injecteur de sorte que, une fois le réservoir installé, le conduit de l'injecteur est isolé de l'atmosphère extérieure.

Avantageusement, le goulot est vissable dans le conduit de l'injecteur.

L'étanchéité entre le goulot de la bouteille et l'injecteur est assurée par un joint métallique.

Ce réservoir est fabriqué dans un matériau inerte chimiquement vis-à-vis du matériau organique et pouvant supporter des températures entre -50°C et + 600°C sans qu'il ne se déforme ou que ses qualités d'étanchéité soient affectées. Ce réservoir 10 peut être réalisé en métal, graphite, verre, quartz, PBN, PG, alumine ou plusieurs de ces matériaux. Avantageusement, le volume utile de ce réservoir peut aller de 1 cm³ à plusieurs litres.

La surface intérieure du réservoir présente une rugosité très faible.

La forme de ce réservoir est telle qu'elle présente une surface maximale pour le chauffage.

Avantageusement, ce réservoir à un diamètre D > 30mm et le rapport de la hauteur et du diamètre est supérieur à deux.

Le réservoir peut être équipé, en plus d'un orifice de remplissage, d'une ou plusieurs entrées différentes permettant par exemple l'introduction d'un gaz inerte ou réactif dans la recharge et/ou permettant le pompage de l'intérieur de la recharge.

Lorsque le réservoir est détaché de l'injecteur 110 et fermé par un bouchon 130, il est étanche vis-à-vis de l'extérieur et peut conserver un vide de l'ordre de 10⁻⁸ torr sans pompage pendant 1 semaine.

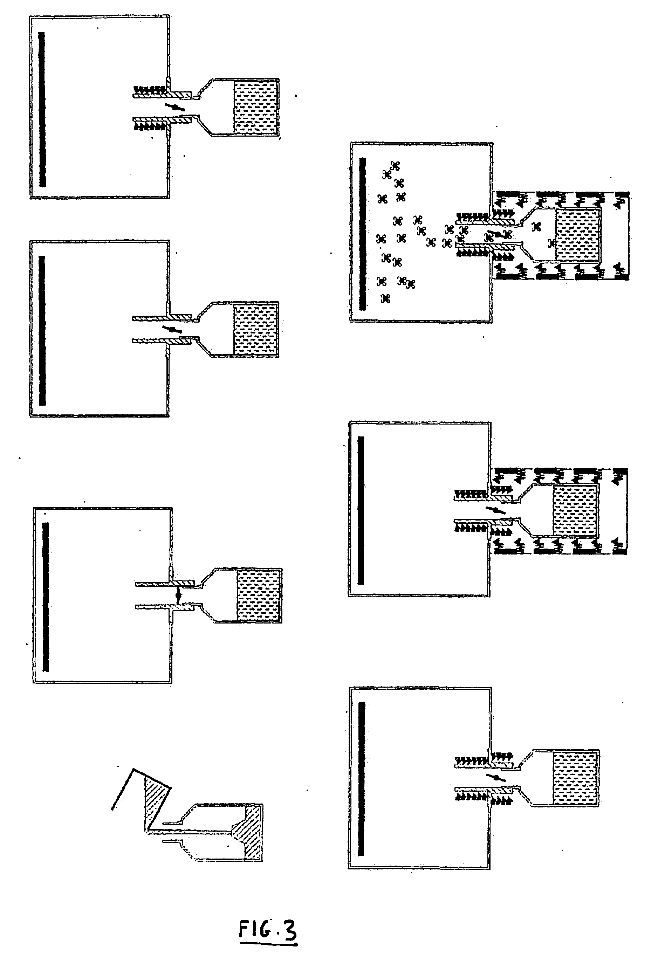

La figure 3 représente des modes alternatifs de réalisation du réservoir 10. Dans tous ces modes de réalisation, la forme de l'extrémité du goulot est identique de sorte que chacun des réservoirs représentés peut être installé sur l'embout de l'injecteur 3. Un bouchon 130 permet la fermeture du réservoir lorsqu'il n'est pas monté sur l'injecteur 3.

Dans un premier mode de réalisation 10A alternatif, une pluralité d'ailettes métalliques 150 s'étendent radialement entre la paroi 152 du réservoir et un tube central 151 s'étendant sur toute la hauteur dudit corps cylindrique.

Ce dispositif permet d'améliorer la transmission de la chaleur vers l'intérieur du réservoir, de manière à éviter l'accumulation du produit dans la zone centrale du réservoir.

Dans un mode de réalisation 10C, le réservoir a un corps cylindrique de section annulaire de sorte qu'un logement ouvert vers le bas 170 s'étend le long de son axe. Un dispositif de chauffage peut être introduit axialement par le fond afin d'éviter l'accumulation du produit dans la zone centrale du réservoir.

Dans un mode de réalisation 10B, une vanne 160 est installée au niveau du goulot du réservoir.

Bien entendu, les caractéristiques de ces trois modes de réalisation peuvent être conjuguées sur un même réservoir.

Un four amovible 50 permet de chauffer le réservoir 10. Ce four est constitué d'un caisson fermé au niveau de sa partie inférieure et ouvert au niveau de sa partie supérieure. Le diamètre intérieur de ce four est accueillir la bouteille 10 et à venir s'enmancher sur la paroi extérieure 140 du compartiment d'injection 5, de manière à former une cavité fermée renfermant la bouteille. Des éléments chauffants intégrés aux parois du caisson du four 50 dont répartis dans le caisson de manière à chauffer les parois du réservoir 10 et la paroi 140 du compartiment d'injection 5. Ces éléments chauffants sont par exemple des lampes ou des résistances chauffantes. Le four 50 comprend un dispositif de mesure de température permettant de mesurer la température du réservoir (thermocouple ou sonde platine). Les éléments chauffants du four sont alimentés en puissance par une alimentation indépendante qui peut être régulée en température au moyen du dispositif de mesure de température.

Le four amovible 50 a notamment pour rôle de porter la charge à la température voulue pour la génération du jet moléculaire. Avantageusement, cette température est comprise entre 50 et 600 degrés.

Le système de chauffage 50 se trouve entièrement à l'extérieur de l'enceinte 1 et est indépendant de cette dernière.

Selon un autre aspect de la présente invention, le conduit de la partie intérieure 110 de l'injecteur est chauffé à l'aide d'un dispositif de chauffage intérieur 30. Un élément chauffant, par exemple un câble chauffant, entoure la surface extérieure du cylindre d'injecteur intérieur 110 et s'étend également (par exemple en spirale) contre la surface intérieure de la paroi inférieure 141 du compartiment d'injection 5. De la sorte, l'injecteur est chauffé uniformément de sa base au niveau de la traversée de cloison jusqu'à son embouchure intérieure. Un moyen de mesure de la température au niveau de l'extrémité de l'injecteur (thermocouple ou sonde platine) permet de mesurer la température au niveau de l'embouchure intérieure de l'injecteur. L'élément chauffant de l'injecteur est alimenté en puissance à l'aide d'une alimentation indépendante qui peut être régulée en température au moyen du dispositif de mesure de température.

Selon un autre aspect de la présente invention, la vanne 20 est chauffée à l'aide d'un dispositif de chauffage de vanne 40 intervenant à l'intérieur du compartiment d'injection 5. Un élément chauffant, par exemple un câble chauffant, entoure la tige de commande 142, la chaleur étant transmise au corps de la vanne par conduction. Un dispositif de mesure de température est installé sur le corps de la vanne. L'élément chauffant de la vanne est alimenté en puissance à l'aide d'une alimentation indépendante qui peut être régulée en température au moyen du dispositif de mesure de température.

Le dispositif de chauffage 30 chauffe les parois de l'injecteur de manière à ce que la charge ne se dépose pas sur ces parois, et le dispositif de chauffage 40 chauffe la vanne 30 de sorte que la charge ne se dépose pas sur cette vanne. Les dispositifs de chauffage 30 et 40 sont indépendants l'un de l'autre et du dispositif de chauffage 50.

Selon un mode de réalisation alternatif envisagé, les dispositifs de chauffage permettent également un refroidissement des différents éléments de l'injecteur.

Selon un autre aspect de la présente invention, les dispositifs de chauffage 50, 40 et 30 chauffent respectivement le réservoir, la vanne et l'injecteur de manière à ce qu'il y ait un gradiant de température entre la base et le goulot du réservoir, entre le goulot et la vanne et entre la vanne et l'embouchure intérieure de l'injecteur. Autrement dit, la température de la base du réservoir est inférieure à la température au niveau du goulot, elle même inférieure à celle de la vanne et elle même inférieure à celle de l'embouchure intérieure de l'injecteur. Le contrôle du gradient est assuré au moyen des alimentations indépendantes des trois moyens de chauffage associées à des capteurs de température. Les éléments chauffants dans le réservoir 50 sont disposés de manière à chauffer plus le bas que le haut du réservoir. De même, la répartition des longueurs d'enroulement du câble chauffant 30 est choisie en vue de fournir une répartition de puissance sur la hauteur de l'injecteur assurant ce gradiant. Le fait que le chauffage du réservoir permette de chauffer de l'extérieur la surface extérieure 140 de la paroi inférieure du compartiment d'injection 5 et que le chauffage de l'injecteur permette de chauffer de l'intérieur la surface intérieure 141 de cette même paroi permet de garantir la continuité du gradient de température du conduit de l'injecteur entre l'extérieur et l'intérieur.

La figure 3 représente schématiquement plusieurs étapes de charge ou de recharge dans le cadre d'un procédé de dépôt sous vide. Ces étapes de charge ou de recharge interviennent alors que l'enceinte 1 est sous vide, la vanne 20 fermant l'orifice de l'injecteur.

## Revendications

1. Dispositif de dépôt sous vide comprenant une enceinte (1) adaptée à recevoir un substrat (2) à traiter et à être mise sous vide et au moins un injecteur (110) pour générer un jet moléculaire de vapeur d'un matériau organique, ledit injecteur (110) comprenant un conduit se trouvant à l'intérieur de ladite enceinte et traversant une paroi d'injection (141) de ladite enceinte pour former un embout extérieur (120) adapté à être raccordé hermétiquement, de manière détachable, à un moyen d'alimentation en matériau organique, **caractérisé en ce que** ledit moyen d'alimentation est une bouteille (10) dont le goulot (11) est adapté à être introduit dans ledit embout (120) et **en ce que** ledit dispositif de dépôt comprend, de part et d'autre de ladite paroi d'injection (141), un dispositif extérieur de chauffage (50) entourant ladite bouteille et un dispositif intérieur de chauffage (30) entourant ledit conduit, une vanne (20) réglable permettant de régler la conductance de l'injecteur intervenant à l'intérieur de l'enceinte.

2. Dispositif de dépôt sous vide selon la revendication 1, **caractérisé en ce que** ladite vanne (20) dudit injecteur (110) est pourvue d'un dispositif de chauffage (40) adapté à empêcher le dépôt du matériau organique sur ladite vanne.

3. Dispositif de dépôt sous vide selon l'une quelconque des revendications précédentes, **caractérisé en ce que** ledit réservoir amovible (10) peut être rempli de matériau organique solide, mis sous vide et fermé par un bouchon (130) de manière à conserver un vide de l'ordre de 10⁻⁸ torr pendant une semaine.

4. Dispositif de dépôt sous vide selon l'une quelconque des revendications précédentes, **caractérisé en ce que** ladite bouteille (10A) comprend une pluralité d'ailettes métalliques (150) s'étendant radialement entre la paroi (152) dudit réservoir et un tube central (151) s'étendant sur toute la hauteur dudit corps cylindrique.

5. Dispositif de dépôt sous vide selon l'une quelconque des revendications précédentes, **caractérisé en ce que** ladite bouteille (10C) a un corps cylindrique de section annulaire.

6. Dispositif de dépôt sous vide selon l'une quelconque des revendications précédentes, **caractérisé en ce que** ladite bouteille (10B) est pourvue d'une vanne (160) au niveau de son goulot.

7. Dispositif de dépôt sous vide selon l'une quelconque des revendications précédentes, **caractérisé en ce que** ledit conduit dudit injecteur (110) est vertical et traverse le fond de ladite enceinte à vide (1), ledit substrat (2) s'étendant horizontalement dans une partie supérieure de ladite enceinte.

8. Dispositif de dépôt sous vide selon l'une quelconque des revendications précédentes, **caractérisé en ce que** ledit four de chauffage (50) chauffe ladite bouteille (10) avec un gradient de température entre la base et le goulot (11) de cette bouteille, entre ledit goulot (11) et ladite vanne (20) et entre ladite vanne (20) et l'embouchure intérieure dudit injecteur (120).

9. Procédé de dépôt sous vide utilisant un dispositif selon l'une quelconque des revendications précédentes, **caractérisé en ce qu'**il comprend les étapes de recharge consistant à :
fermer ladite vanne (20);
détacher ladite bouteille (10) dudit injecteur (110); recharger ladite bouteille (10)
raccorder une autre bouteille (10) audit injecteur (110);
ouvrir progressivement la vanne (21);
chauffer ledit conduit (113) dudit injecteur (110);
chauffer ladite vanne (20); et
chauffer ladite autre bouteille (10).

## Patentansprüche

1. Vorrichtung zur Vakuumabscheidung, umfassend einen Raum (1), der dazu ausgelegt ist, ein zu behandelndes Substrat (2) aufzunehmen und evakuiert zu werden, sowie wenigstens einen Injektor (110) zum Erzeugen eines molekularen Dampfstrahls eines organischen Materials, wobei der Injektor (110) eine Leitung umfasst, die sich innerhalb des Raumes befindet und die eine Injektionswand (141) des Raumes durchgreift, um einen Außenstutzen (120) zu bilden, der dazu ausgelegt ist, auf hermetische Weise lösbar an ein Mittel zum Zuführen von organischem Material angeschlossen zu werden, **dadurch gekennzeichnet, dass** das Zuführmittel eine Flasche (10) ist, deren Flaschenhals (11) dazu ausgelegt ist, in den Stutzen (120) eingeführt zu werden, und dass die Abscheidungsvorrichtung auf beiden Seiten der Injektionswand (141) eine äußere Heizvorrichtung (50), welche die Flasche umschließt, sowie eine innere Heizvorrichtung (30), welche die Leitung umschließt, umfasst, wobei ein einstellbares Ventil (20), das ermöglicht, den Leitwert des Injektors einzustellen, innerhalb des Raumes zum Einsatz kommt.

2. Vorrichtung zur Vakuumabscheidung nach Anspruch 1, **dadurch gekennzeichnet, dass** das Ventil (20) des Injektors (110) mit einer Heizvorrichtung (40) versehen ist, die dazu ausgelegt ist, das Abscheiden des organischen Materials auf dem Ventil zu verhindern.

3. Vorrichtung zur Vakuumabscheidung nach einem der vorhergehenden Ansprüche, **dadurch gekennzeichnet, dass** der lösbare Behälter (10) mit festem organischem Material gefüllt, evakuiert und mit einem Stopfen (130) verschlossen werden kann, um ein Vakuum in der Größenordnung von 10⁻⁸ Torr über eine Woche beizubehalten.

4. Vorrichtung zur Vakuumabscheidung nach einem der vorhergehenden Ansprüche, **dadurch gekennzeichnet, dass** die Flasche (10A) eine Vielzahl von Metallrippen (150) umfasst, die zwischen der Wand (152) des Behälters und einem mittleren Rohr (151), welches sich über die gesamte Höhe des zylindrischen Körpers erstreckt, radial verlaufen.

5. Vorrichtung zur Vakuumabscheidung nach einem der vorhergehenden Ansprüche, **dadurch gekennzeichnet, dass** die Flasche (10C) einen zylindrischen Körper mit ringförmigem Querschnitt aufweist.

6. Vorrichtung zur Vakuumabscheidung nach einem der vorhergehenden Ansprüche, **dadurch gekennzeichnet, dass** die Flasche (10B) im Bereich ihres Flaschenhalses mit einem Ventil (160) versehen ist.

7. Vorrichtung zur Vakuumabscheidung nach einem der vorhergehenden Ansprüche, **dadurch gekennzeichnet, dass** die Leitung des Injektors (110) vertikal ist und den Boden des Vakuumraumes (1) durchgreift, wobei das Substrat (2) sich in einem oberen Teil des Raumes horizontal erstreckt.

8. Vorrichtung zur Vakuumabscheidung nach einem der vorhergehenden Ansprüche, **dadurch gekennzeichnet, dass** der Erwärmungsofen (50) die Flasche (10) mit einem Temperaturgradienten zwischen der Basis und dem Flaschenhals (11) dieser Flasche, zwischen dem Flaschenhals (11) und dem Ventil (20) sowie zwischen dem Ventil (20) und der Innenmündung des Injektors (120) erhitzt.

9. Verfahren zur Vakuumabscheidung, das eine Vorrichtung nach einem der vorhergehenden Ansprüche verwendet, **dadurch gekennzeichnet, dass** es die Nachfüllschritte umfasst, die darin bestehen:
das Ventil (20) zu schließen;
die Flasche (10) von dem Injektor (110) zu lösen;
die Flasche (10) wieder aufzutanken;
eine andere Flasche (10) an den Injektor (110) anzuschließen;
das Ventil (20) schrittweise zu öffnen;
die Leitung des Injektors (110) zu erhitzen;
das Ventil (20) zu erhitzen und
die andere Flasche (10) zu erhitzen.

## Claims

1. A vacuum deposition apparatus comprising an enclosure (1) adapted to receive a substrate (2) to be treated and to be placed under a vacuum and at least one injector (110) for generating a molecular beam of vapor of an organic material, which injector (110) comprises a conduit located inside the enclosure and traversing an injection wall (141) of this enclosure in order to form an outer nozzle (120) adapted in such a manner as to be hermetically connected in a detachable manner to a means for supplying organic material, **characterized in that** this supply means is a bottle (10) whose neck (11) is adapted to be introduced into this nozzle (120) and **in that** this deposition apparatus comprises an outer heating apparatus (50) located on both sides of this injection wall (141) and surrounding this bottle and an inner heating apparatus (30) surrounding this conduit, and **in that** an adjustable valve (20) permits the regulation of the conductance of the injector in the enclosure.

2. The vacuum deposition apparatus according to claim 1, **characterized in that** this valve (20) of this injector (110) is provided with a heating apparatus (40) adapted to prevent the deposition of the organic material on this valve.

3. The vacuum deposition apparatus according to any one of the previous claims, **characterized in that** this removable reservoir (10) can be filled with solid organic material, placed under a vacuum and closed by a plug (130) in such a manner as to preserve a vacuum on the order of 10⁻⁸ torr for one week.

4. The vacuum deposition apparatus according to any one of the previous claims, **characterized in that** this bottle (10A) comprises a plurality of metallic blades (150) that extend radially between the wall (152) of this reservoir and a central tube (151) extending over the entire length of this cylindrical body.

5. The vacuum deposition apparatus according to any one of the previous claims, **characterized in that** this bottle (10C) has a cylindrical body with an annular section.

6. The vacuum deposition apparatus according to any one of the previous claims, **characterized in that** this bottle (10B) is provided with a valve (160) at the level of its neck.

7. The vacuum deposition apparatus according to any one of the previous claims, **characterized in that** this conduit of this injector (110) is vertical and traverses the bottom of this vacuum enclosure (1) and **in that** this substrate (2) extends horizontally in an upper part of this enclosure.

8. The vacuum deposition apparatus according to any one of the previous claims, **characterized in that** this heating furnace (50) heats this bottle (10) with a temperature gradient between the base and the neck (11) of this bottle, between this neck (11) and this valve (20), and between this valve (20) and the inner mouth of this injector (120).

9. A vacuum deposition process using an apparatus according to any one of the previous claims, **characterized in that** it comprises the recharging steps consisting in:
closing this valve (20);
detaching this bottle (10) from this injector (110);
recharging this bottle (10);
connecting another bottle (10) to this injector (110);
progressively opening the valve (20);
heating this conduit of this injector (110);
heating this valve (20); and
heating this another bottle (10).
